Europäisches Patentamt

European Patent Office

Office européen des brevets

(19)

(11) Publication number: **0 310 247**

**A2**

(12) # EUROPEAN PATENT APPLICATION

(21) Application number: **88308080.6**

(22) Date of filing: **01.09.88**

(51) Int. Cl.4: **H01L 39/24 , C23C 18/02 , H01L 39/12**

(30) Priority: **22.12.87 US 136585**
**30.09.87 US 103245**

(43) Date of publication of application:
**05.04.89 Bulletin 89/14**

(84) Designated Contracting States:
**DE FR GB**

(71) Applicant: **GENERAL MOTORS CORPORATION**
**General Motors Building 3044 West Grand Boulevard**
**Detroit Michigan 48202(US)**

(72) Inventor: **Mantese, Joseph V.**
**61331 Windwood Ct.**
**Washington MI 48094(US)**
Inventor: **Hamdi, Aboud H.**
**3988 Dorothy Street**
**Detroit Michigan 48211(US)**
Inventor: **Micheli, Adolph L.**
**38900 Elmite**
**Mt. Clemens Michigan 48045(US)**

(74) Representative: **Haines, Arthur Donald et al**
**Patent Section (F6) Vauxhall Motors Limited**
**P.O. Box 3 Kimpton Road**
**Luton, Beds. LU2 OSY(GB)**

(54) **Ytterbium, barium, copper oxide film superconductors.**

(57) Superconducting thin films of $Yb_1Ba_2Cu_4O_z$, where Yb represents ytterbium, Ba represents barium, Cu represents copper, 0 represents oxygen, and z is a value ranging between about 6 to 8, are produced in a non-vacuum environment using Metallo-Organic Deposition techniques. An ink comprising the neodecanoates of the ytterbium, barium, and copper is formed and spun on a single crystal substrate of strontium titanate. The ink is dried in an air environment, heated in an air environment at a temperature sufficient to decompose the neodecanoates, about 500°C, and then annealed to promote recrystallization and grain growth of the remaining metal oxides. The annealing step is preferably accomplished using rapid thermal annealing techniques wherein the material is uniformly and rapidly heated to an appropriate temperature for an amount of time ranging up to about 2 minutes. The resulting films of material exhibit superconductive characteristics at elevated temperatures above the temperature of liquid nitrogen.

## YTTERBIUM, BARIUM, COPPER OXIDE FILM SUPERCONDUCTORS

This invention relates to superconductors and methods of making films of superconductor materials as specified in the preamble of claim 1, for example as disclosed in the article entitled "Preparation of Y-Ba-Cu oxide superconductor thin films using pulsed laser evaporation from high $T_c$ bulk material" by Dijkkamp et al, Appl. Phys. Lett. 51(8), 24 August 1987.

### Background of the Invention

Since the first report of a material having a superconducting transition temperature of about 40° K, there has been extensive activity in the field to develop materials having an even higher range of superconducting transition temperatures. A wide variety of superconductor materials having high transition temperatures have been reported, including superconducting materials comprising yttrium, barium, and copper which have transition temperatures greater than about 80° K. Thin film superconductors based upon these yttrium, barium, and copper compounds have been prepared by sputtering, E-beam and laser evaporation, all techniques requiring vacuum processing. As new materials with ever increasing transition temperatures are sought and developed, it is desirable to have a means for preparing thin films of these superconducting materials which uses non-vacuum techniques, permits easy alteration of chemical components, and is compatible with other film processing techniques.

Examples of such superconducting materials prepared using metallo-organic deposition techniques are disclosed in our co-pending patent application in Europe, Serial No. , filed on the same date.

Metallo-Organic Deposition (MOD) is an entirely non-vacuum method of film deposition. A metallo-organic compound is a compound formed from a metal and an organic radical, such as, for example, barium neodecanoate. Typically, a liquid solution of metallo-organic compounds is prepared by dissolution of the metallo-organic compounds in a suitable solvent. This solution is then applied much in the same manner as photo-resist compositions, as by spin-coating the organic solution onto a selected substrate material. The soft metallo-organic film is then heated in air or oxygen to burn out the organic components and produce a thin film of metal oxides. By utilizing non-vacuum processing techniques, the Metallo-Organic Deposition method provides an economical means for film preparation of semi-conductor materials. In addition, the ease in which compounds of a variety of elements can be made allows a wide range of multi-metal compounds to be prepared.

### Summary of the Invention

A method for producing films of superconductor materials according to the present invention is characterised by the features specified in the characterising portion of claim 1.

It is an object of the present invention to provide superconductor films, particularly a superconductor film containing the rare earth metal ytterbium.

It is a further object of this invention to provide a method for forming films of superconductor materials.

It is still a further object of this invention that these superconductor films be formed in a non-vacuum, air environment.

In accordance with a preferred embodiment of this invention, these and other objects and advantages are accomplished as follows.

Thin film superconductors have been prepared for the first time in a non-vacuum, air environment using metallo-organic deposition techniques. Superconducting thin films, comprising barium, copper, and a rare earth (RE) metal, were formed on single crystal strontium titanate substrates by the thermal decomposition of an ink-forming solution of the neodecanoates of the barium, copper, and rare earth metal. The preferred rare earth metals include yttrium, ytterbium, and europium.

An ink-forming solution was prepared containing the neodecanoates of the barium, copper, and ytterbium. Preferentially, the ink contained about 1 gram of the combined metal neodecanoates to about 1 millilitre of solvent. An ink of the preferred composition was spun onto a strontium titanate substrate at about 2000 revolutions per minute. The spun-on ink was dried in air at about 110° C for about five minutes, then immediately placed into a furnace set at 500° C and baked in air at this temperature for about five minutes so as to decompose the metal neodecanoates leaving only a metal oxide film on the substrate surface. It is preferred that the freshly prepared inks not remain at ambient conditions for too long. The film was then rapidly thermally annealed at about 920° C in an oxygen-containing atmosphere for an amount of time ranging up to about 2 minutes, and subsequently rapidly quenched to room temperature.

Rutherford Backscattering Spectrometry was used to determine that the empirical composition resulting film prepared in accordance with this method was approximately $Yb_1Ba_2Cu_4O_z$. This method may be employed to produce superconducting films of the rare earth (RE) metals having a general empirical composition of approximately $RE_1Ba_2Cu_4O_z$, and wherein the rare earth metal is chosen from the group consisting of yttrium, ytterbium, europium, or a yttrium/europium combination. A superconducting film prepared in accordance with this method, comprising ytterbium and having an approximate empirical composition $Yb_1Ba_2Cu_4O_z$, is characterized by a zero state resistance temperature of about 84K and a superconducting transition temperature of about 90K. A superconducting film prepared in accordance with this method, comprising europium and having an approximate empirical composition $Eu_1Ba_2Cu_4O_z$, exhibited a zero state resistance temperature of about 20K and a superconducting transition temperature of about 70K. Electrical measurements show a zero state resistance temperature of about 70K for a superconducting film $Y_1Ba_2Cu_4O_z$, and a superconducting transition temperature of about 90K.

Other objects and advantages of this invention will be better appreciated from a detailed description thereof, which follows.


Detailed Description of the Invention

In the present invention, metallo-organic inks are prepared using carboxylates of a rare earth (RE) metal, barium, and copper. The preferred carboxylates are the neodecanoates of the various metals. The preferred rare earth metals are yttrium, ytterbium, and europium. Rutherford Backscattering Spectrometry analysis was used to determine film composition and thickness. Using this technique, the composition of the inks may be adjusted to obtain desired superconducting compositions.

The Rutherford Backscattering Spectrometry analysis revealed that the relative metal compositions of the preferred thin films were approximately $RE_1Ba_2Cu_4O_z$, with z ranging between 6-8, where the rare earth (RE) metal comprises yttrium, ytterbium, or europium. Using Rutherford Backscattering Spectrometry, the relative compositions for the ytterbium-containing films and the europium-containing films could not be determined precisely, since the relatively heavy atomic weight of ytterbium and europium prevented the accurate detection of these metals, as the heavy metals were not entirely distinguishable from the barium in the composition. In addition, the concentration of oxygen in the thin films could not be determined precisely from the Rutherford Backscattering Spectrometry spectrum because the oxygen signal from the sapphire substrate on which the thin film coatings were formed overlapped that of the oxygen signal from the superconducting thin films. It is believed that in the empirical formula $RE_1Ba_2Cu_4O_z$, z ranges between about 6 to about 8, as this corresponds to the metal ratios and results in superconductive characteristics.

The usual solvent for the metal neodecanoates is xylene, however it was observed that the yttrium, ytterbium, and europium neodecanoates gel in xylene forming an unusable ink. It was found that the addition of approximately about 5 to about 10 percent pyridine by volume to the xylene forms a solvent that will not gel these neodecanoates. In addition, it was observed that the addition of the pyridine in two separate steps forms superior metallo-organic inks. First, the barium, copper, and rare earth neodecanoates are dissolved by stirring the neodecanoates in a 95% xylene and 5% pyridine solvent for approximately ten hours at room temperature. An additional amount of pyridine, about 1 to about 5 percent, is subsequently added to the metallo-organic ink after the first stirring step and the ink is further stirred for approximately one hour. Formation of a solution of the metal neodecanoates ensures intimate mixing between the elements of the solution which will ultimately form the superconducting compound.

Inks prepared using this method are spun on smooth strontium titanate substrates and then fired to decompose the neodecanoates within the metallo-organic ink. The method of firing the ink onto the substrate is critical, in that thermogravimetric analysis shows that the metal neodecanoates of the rare earth metal, the copper and the barium volatilize and decompose at different temperatures to one another. It was determined that the freshly-prepared metallo-organic inks, which have been spun onto the substrates, should be immediately placed in a furnace preheated to about 500°C. This step results in high-quality thin films of the superconducting composition. After the firing step an oxide film of the appropriate metal oxide composition remains on the substrate, the relative amounts of the metal remaining on the surface reliably corresponding to the amount of metal in the original inks. Using this method, the composition of the metallo-organic inks may be adjusted to obtain various compositions in the oxide films.

The ink is carefully poured onto the top surface of a stationary strontium titanate substrate, so as to flood the surface. The substrates are about one centimetre square by about 0.15 centimetre height, oriented in the 100 crystal direction. The viscous metallo-organic inks are spun onto the substrate surface at various speeds. After 20 seconds at about 2000 revolutions per minute (RPM), after drying at about 85°C so as to evaporate any solvent the thickness of the ink will be about 4.4 micrometres, and the thickness of the metal oxide film, after heating to about 500°C so as to decompose the neodecanoates, will be about 260 nanometres (2600 Angstroms). After 20 seconds at 3000 RPM and drying at 85°C the thickness of the ink will be about 3.7 micrometres and the thickness of the oxide film, after heating at about 500°C, will be about 210 nanometres (2100 Angstroms). After about 20 seconds at 4000 RPM, the corresponding thicknesses of the ink film and the oxide film after drying the ink film at 85°C and heating the oxide film at 500°C are about 3.1 micrometres and 209 nanometres (2090 Angstroms) respectively. After about 20 seconds at 7000 RPM, the corresponding thicknesses of the ink film and the oxide film after drying the ink film at 85°C and heating the oxide film at 500°C are about 2.6 micrometres and 170 nanometres (1700 Angstroms) respectively. These measurements were determined using a step profile detector.

This two-step sequence of first spinning the metallo-organic ink onto the substrate followed immediately by the firing thereof at a temperature sufficient to decompose the metal neodecanoates, may be repeated so as to produce oxide films having a thickness of up to about 2.0 micrometres. These films may be processed, by employing multiple deposition techniques in accordance with this invention, to result in thicker films for optimal superconducting characteristics, if desired.

After repeating the spinning and firing sequence sufficiently so as to achieve the desired metal oxide thickness on the substrate, the films are then annealed in a non-vacuum oxygen-containing environment at atmospheric pressure and a sufficient temperature for a period of time sufficient to promote recrystallization and grain growth within the metal oxides. The resulting films are characterized by superconductive electrical properties. It is preferred that the metal oxide films be rapidly thermally annealed, i.e., exposed to the annealing temperature for a relatively short period of time of up to about 2 minutes. It has been determined that the use of rapid thermal annealing techniques produce superconducting films characterized by higher zero state resistance temperatures than the superconducting films which are produced from conventionally annealed oxide films by baking said films at the desired temperature for a longer duration, i.e., about 6 hours.

Rapid thermal annealing techniques raise the temperature of the substrate and deposited film uniformly and almost instantaneously to the desired annealing temperature. Two methods are generally employed for rapid thermal annealing. The first method, which is the preferred method, comprises heating the material using quartz lamps. The quartz lamps generate extremely large dosages of electromagnetic infra-red radiation in the form of light. The substrates and films are heated very rapidly by exposing the substrates to the electromagnetic radiation generated by the quartz lamps. The second method involves placing the substrates and films on a graphite receptacle and exposing the substrates to microwaves. The microwaves impinge the films deposited on the surface of the substrate and heat the film and substrate uniformly and quickly.

Superconducting films containing the rare earth metal, ytterbium, and having an empirical composition of $Yb_1Ba_2Cu_4O_z$, were produced using this metallo-organic deposition method. A metallo-organic ink was prepared using the neodecanoates of ytterbium, barium, and copper. The ytterbium and the barium neodecanoates were formed from their metal acetates by reaction with ammonium neodecanoate. The copper neodecanoates was formed by a reaction of copper (II) acetate with tetramethyl ammonium neodecanoate. The metal neodecanoates were dissolved in a solvent solution containing approximately 5 volume percent pyridine in xylene, and stirred for approximately 10 hours. An additional 1-5 volume percent pyridine was added to the solution and stirred for about another hour. Solutions containing the ytterbium, barium, and copper neodecanoates, of various concentrations, may be made by dissolving the three components in appropriate amounts of xylene and pyridine.

The ytterbium-containing solution, i.e., ink, which resulted in the superconductor film composition of $Yb_1Ba_2Cu_4O_z$, had an approximate ratio of about one gram of the combined metal neodecanoates to about one millilitre of solvent. Approximately 16.62 grams of the ytterbium neodecanoate, 19.12 grams of the barium neodecanoate, and 13.76 grams of the copper neodecanoate, yielding a total of about 49.50 grams of metal neodecanoates, were dissolved in about 49.50 millilitres of solvent, the solvent comprising about 47.02 millilitres of xylene with about 2.48 millilitres of pyridine. The ink was stirred for approximately 10 hours at room temperature. Then an additional 1 to 5 percent pyridine was added, and stirring was continued for approximately another hour. The addition of the pyridine in two steps followed by the stirring step is preferred and results in a superior metallo-organic ink for purposes of preparing the superconducting films. However, suitable results are obtained when the pyridine is added in a single step also. The solutions were viscous, having a viscosity of approximately about 0.014 Pas (14 centipoise) and were filtered, using Teflon (R.T.M.) membranes, to remove particles down to approximately 200 nanometres in size.

The inks prepared from the ytterbium, barium, and copper neodecanoates and solvents were flooded onto stationary single crystal strontium titanate, $SrTiO_3$, substrates of about one centimetre width by about one centimetre length by about 0.15 centimetre height, oriented in the <100> crystal direction. The inks were spun dry on the substrates at various speeds, about 2000 revolutions per minute for about 20 seconds being preferred. The spun-on inks were dried in air at about 110°C for about five minutes, then immediately placed in a furnace pre-heated to about 500°C. The thin ink films were heated in air at that temperature, 500°C, for about 5 minutes to decompose the ytterbium, barium, and copper neodecanoates. This two-step, spin-on and fire, deposition sequence was typically repeated many times to obtain a desired film thickness between about 1.5 and 2.0 micrometres, however multiple depositions are not an essential feature of the method of the invention. It is foreseeable that suitable results may be obtained at film thicknesses as small as about 0.1 micrometres.

Thermogravimetric analysis shows that the metal neodecanoates volatize and decompose at different temperatures to one another. Complete decomposition of the combined ytterbium, barium, and copper neodecanoates used in this invention occurs at about 450°C, leaving only the ytterbium, barium, and copper oxides remaining on the strontium titanate substrate in amounts proportional to the amount of metal in the original metallo-organic ink. It has been found that, if the dried inks on the substrates are immediately placed in a furnace set at about 500°C, after the drying step at about 110°C, high-quality thin oxide films are produced for preparing superconducting films therefrom. The grain sizes of the superconducting thin films prepared in accordance with this invention, using metallo-organic deposition techniques, were estimated to be about 250 nanometres in diameter.

After obtaining the desired thickness of the ink and completing the subsequent firing required to decompose the organic neodecanoates and leave only the metal oxides remaining on the substrate, the samples were annealed in a non-vacuum, oxygen-containing environment to promote recrystallization and grain growth within the material. Preferably, the films were rapidly thermally annealed at about 920°C in an oxygen-containing atmosphere at atmospheric pressure for an amount of time up to about 2 minutes, followed by rapidly quenching the films to room temperature. The resulting films of $Yb_1Ba_2Cu_4O_z$, prepared in accordance with this method, exhibit superconductive characteristics.

A ytterbium-containing film having the approximate empirical composition $Yb_1Ba_2Cu_4O_z$ as determined by Rutherford Backscattering Spectrometry, was prepared in accordance with the above described metallo-organic deposition method and rapidly thermally annealed in pure oxygen first at a temperature of about 850°C for about 45 seconds and subsequently at a second temperature of about 920°C for about 30 seconds, and then was quenched in air to room temperature. Silver paint was used to make four probe resistance measurements. A zero point resistance temperature of about 84K was measured. Zero point resistance temperature is defined as that temperature which corresponds to a resistivity limit set at $7.6 \times 10^{-8}$ ohms per centimetre. The room temperature resistivity of the film was found to be approximately $1.2 \times 10^{-3}$ ohms per centimetre. This material is further characterized by a superconducting transition temperature of at least 90K, where a rapid drop in resistance was observed. X-ray analysis revealed that the superconducting grains within the films were epitaxial with the c-axis perpendicular to the <100> strontium titanate substrate, an orientation which enhances the current carrying capacity of the films.

Although the $Yb_1Ba_2Cu_4O_z$ film was rapidly thermally annealed at a first temperature of about 850°C for about 45 seconds and followed by rapid thermal annealing at a second temperature of about 920°C for about 30 seconds, it is believed that this two-step rapid thermal annealing step is not essential. It is believed that this double annealing step may be beneficial in that the first lower temperature exposure may promote nucleation within the material, whilst the second higher temperature exposure facilitates incongruent melting within the composition. It is generally known that the presence of a liquid phase greatly enhances grain growth within ceramic materials. However, a single rapid thermal annealing step at 920°C for an amount of time up to about 2 minutes is believed to be sufficient to produce superconducting films. It is preferred that the material be annealed at a temperature ranging between about 850°C to about 1000°C and for a duration of time up to about 2 minutes, with about 15 seconds to one minute being especially preferred. The duration and annealing temperature are inversely related to one another; i.e, a shorter duration is required at a higher temperature. In addition, suitable results should be obtained using more conventional annealing techniques such as annealing at about 850°C to about 1000°C for a sufficient time to promote recrystallization and grain growth.

Superconducting films comprising the rare earth metal, europium, and having an empirical

composition of $Eu_1Ba_2Cu_4O_z$, were also produced using this metallo-organic deposition method. The europium-containing superconducting material was rapidly thermally annealed at about 930°C in a pure oxygen environment for about 45 seconds and quenched in air. The material is characterized by a zero point resistance temperature of about 20K and a superconducting transition temperature of about 70K.

In addition, superconducting films comprising the rare earth metal, yttrium, and having an empirical composition of $Y_1Ba_2Cu_4O_z$, were produced using this metallo-organic deposition method. The yttrium-containing superconducting material was rapidly thermally annealed at about 920°C for about 1 minute in a pure oxygen environment and quenched in air. The material is characterized by a zero point resistance temperature of about 70K and a superconducting transition temperature of at least about 90K. Materials of the same composition were also prepared by annealing at 850°C for about 6 hours and slow-cooling to room temperature. These materials were characterized by superconducting transition temperatures which were slightly lower than the materials which were rapidly thermally annealed and air-quenched.

With this invention, superconducting thin films of various compositions comprising a rare earth metal have also been formed on barium titanate and sapphire substrates. Other suitable diffusion and temperature-resistant materials may also be used as the substrate.

This invention readily facilitates modification of the metal constituents and their ratios in the thin films, to obtain optimal superconducting characteristics within the thin films. This invention is also an entirely non-vacuum process which is compatible with film processing techniques.

## Claims

1. A method of producing films of superconductor materials by the deposition of a film of a metal oxide mixture on a substrate followed by the annealing of said film in an oxygen atmosphere to form an oxide mixture exhibiting superconductive properties, characterised in that the method comprises the steps of: forming a solution from the neodecanoates of ytterbium, barium, and copper metals; depositing a film of said solution onto a substrate; heating said film in an oxygen-containing environment at a first temperature for a period of time that is (a) sufficient to thermally decompose said metal neodecanoates into said film containing the metal oxide mixture, and (b) insufficient to significantly recrystallize said oxides in said metal oxide mixture; and annealing said film of oxides at a second temperature for a period of time that is sufficient to promote grain growth of said metal oxides within said film and to induce a change therein by which said film exhibits superconducting properties at a significantly increased temperature above the temperature of liquid nitrogen.

2. A method of producing films of superconductor materials according to claim 1, characterised in that said substrate is selected from the group consisting of strontium titanate, barium titanate, and sapphire.

3. A method of producing films of superconductor materials according to claim 1 or 2, characterised in that said first heating step is at a temperature greater than about 450°C but less than about 850°C.

4. A method of producing films of superconductor materials according to claim 1, 2, or 3, characterised in that said annealing step comprises heating said film in an oxygen-containing environment at a temperature greater than said first heating temperature, said second heating temperature being sufficient to promote said grain growth of said metal oxides within said film.

5. A method of producing films of superconductor materials according to any one of the preceding claims, characterised in that said annealing step is a rapid thermal annealing step in which the oxide film is exposed to said second temperature for a period of time that is less than 2 minutes, and the oxide film is then rapidly cooled to ambient temperature at the end of said period of time.

6. A method of producing films of superconductor materials according to any one of the preceding claims, characterised in that said film is heated in said oxygen-containing environment at about 500°C for about 5 minutes, so as to decompose said neodecanoates of ytterbium, barium, and copper into said metal oxide film, containing oxides of ytterbium, barium, and copper.

7. A method of producing films of superconductor materials according to any one of the preceding claims, characterised in that said temperature of the annealing step is in the temperature range of 850°C to 1000°C.

8. A method of producing thin film superconductor materials according to any one of the preceding claims, characterised in that said resulting superconductive metal oxide film has a thickness ranging between about 0.1 micrometres to about 2.0 micrometres.

9. A method of producing thin film superconductor materials according to any one of the preceding claims, characterised in that the method includes the step of drying said deposited film of metal neodecanoates in an oxygen-containing environment at a temperature of about 110° C for about five minutes, prior to thermally decomposing said metal neodecanoates into said metal oxide mixture.

10. A method of producing films of superconductor materials according to any one of the preceding claims, characterised in that the solution comprises ytterbium neodecanoate; barium neodecanoate; copper neodecanoate; and a solvent comprising xylene and about one to about ten volume percent pyridine.

11. A method of producing films of superconductor materials according to claim 10, characterised in that the solution comprises in proportional amounts: about 16.63 grams of ytterbium neodecanoate; about 19.12 grams of barium neodecanoate; about 13.76 grams of copper neodecanoate; and about 49.50 millilitres of said solvent comprising xylene and about one to about ten volume percent pyridine.

12. A superconductive film produced by a method according to any one of the preceding claims.

13. A metal oxide superconducting film containing oxides of ytterbium, barium, and copper, in which the molar ratio of ytterbium to barium to copper is approximately 1:2:4, respectively.

14. A method of producing films of superconductor materials according to claim 1, characterised in that the method includes the steps of: forming said solution from the neodecanoates of ytterbium, barium, and copper, and a solvent, said solvent consisting of xylene and about one to about ten volume percent pyridine; flooding said substrate with said solution, said substrate being selected from the group consisting of strontium titanate, barium titanate, and sapphire; and spin-coating said substrate with said solution at about 2000 revolutions per minute for about 20 seconds.